(19) **Europäisches Patentamt / European Patent Office / Office européen des brevets**

(11) **EP 2 624 308 A1**

(12) **EUROPEAN PATENT APPLICATION**
published in accordance with Art. 153(4) EPC

(43) Date of publication:
**07.08.2013 Bulletin 2013/32**

(21) Application number: **11828561.8**

(22) Date of filing: **30.06.2011**

(51) Int Cl.:
*H01L 31/042* [(2006.01)]     *B32B 27/36* [(2006.01)]

(86) International application number:
**PCT/JP2011/065051**

(87) International publication number:
**WO 2012/043000 (05.04.2012 Gazette 2012/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.09.2010 JP 2010214784**

(71) Applicant: **Mitsubishi Plastics, Inc.**
**Tokyo 100-8252 (JP)**

(72) Inventors:
  • **MASUDA, Narihiro**
  **Maibara-shi**
  **Shiga 521-0234 (JP)**

  • **NOZAWA, Koutarou**
  **Maibara-shi**
  **Shiga 521-0234 (JP)**
  • **KIEHNE, Thorsten**
  **Maibara-shi**
  **Shiga 521-0234 (JP)**

(74) Representative: **Ter Meer Steinmeister & Partner**
**Patentanwälte**
**Mauerkircherstrasse 45**
**81679 München (DE)**

(54) **POLYESTER FILM FOR PROTECTIVE MATERIAL FOR BACK SURFACE OF SOLAR BATTERY**

(57)     The present invention provides a polyester film for a protective material for a backsheet of photovoltaic cells which comprises a colored base film exhibiting an excellent hydrolysis resistance, and further has an excellent wet heat-resistant adhesion property to a sealing resin such as EVA and PVB as a sealing material for photovoltaic cells by providing a coating layer on the colored base film. The present invention relates to a polyester film for a protective material for a backsheet of photovoltaic cells, comprising a polyester film having a carboxyl terminal group content of not more than 26 equivalents/t and comprising a color pigment, and a coating layer formed on at least one surface of the polyester film which comprises a polyurethane having a polycarbonate skeleton or a polyether skeleton, and a crosslinking agent.

**EP 2 624 308 A1**

**Description**

TECHNICAL FIELD

The present invention relates to a polyester film for a protective material for a backsheet of photovoltaic cells, and more particularly, to a polyester film for a protective material for a backsheet of photovoltaic cells in which a colored film having a black color or a deep color is used as a base material film, and which is excellent in hydrolysis resistance and can exhibit an excellent wet heat-resistant adhesion property to sealing resins such as ethylene-vinyl acetate copolymer resins (hereinafter occasionally referred to merely as "EVA") and polyvinyl butyral resins (hereinafter occasionally referred to merely as "PVB") which are used as a sealing material for photovoltaic cells.

BACKGROUND ART

In recent years, solar power generation has been considerably noticed as an energy source useful for prevention of global warming phenomenon, and has already prevailed to a considerable extent. As a typical example of solar power generation, there may be mentioned photovoltaic cells using a semiconductor such as monocrystalline silicon, polycrystalline silicon and amorphous silicon. The photovoltaic cells have been developed on the basis of such a principle that when sunlight is applied to a semiconductor, an electric current is generated from the semiconductor. In recent years, photovoltaic cells having a relatively large size have been noticed. The photovoltaic cells are installed in any sunny places exposed to natural outdoor environments including undeveloped areas such as deserts and waste lands and roofs of houses or large buildings. The photovoltaic cells tend to be considerably deteriorated in performance thereof when water reaches a semiconductor cell as a central part thereof. Therefore, the photovoltaic cells are required to have a high strength and a high water resistance as a package capable of withstanding severe natural environments for a long period of time. In addition, when installed on roofs of housings or the like, the photovoltaic cells have been required to have a reduced weight.

As a typical example of the construction of the photovoltaic modules comprising the above durable package, there are known photovoltaic cells having the following construction. That is, it is generally known that the photovoltaic module has such a construction that cells for the photovoltaic cells, i.e., photoelectric semiconductor elements are sealed by inserting a sealing resin such as EVA between a glass substrate as a front surface-side transparent protective member located on a light receiving side and a protective material film on a rear side thereof. In this construction, EVA serves for fixing the photovoltaic cell.

When using a polyester film as the back surface protective material, adhesion between the polyester film and EVA, etc, tends to be poor, and it is therefore required, for example, to provide an easy-bonding layer or use an adhesive in order to improve an adhesion property therebetween.

In order to improve adhesion between the polyester film and EVA, there has been proposed an easy-bonding polyester film for a backsheet of photovoltaic cells in which a resin coating film comprising a crosslinking agent in an amount of 10 to 100% by weight is applied on the polyester film (Patent Document 1).

Meanwhile, there is the premise that the photovoltaic modules are used outdoors for a long period of time (for example, 20 years or longer) and therefore may be exposed to high-temperature and high-humidity environmental conditions. In this case, there tends to occur such a problem that the polyester film as a sealing material for photovoltaic cells suffers from hydrolysis at an ester bond moiety in a molecular chain thereof, so that mechanical properties of the polyester film by themselves tend to be deteriorated with time. In addition, there tends to be present another problem that an easy-bonding layer for improving a heat-bonding property to EVA, etc., is also deteriorated under high-temperature and high-humidity environmental conditions with time, so that adhesion of the polyester film to EVA, etc., can be hardly maintained.

On the other hand, light leaked from between photovoltaic cells is incident on a protective material film for a backsheet of the photovoltaic cells. In order to allow the leakage light to be reflected and thereby enhance a photoelectric conversion efficiency of the photovoltaic cells, a white polyester film has been frequently used as the protective material for a backsheet of the photovoltaic cells.

However, the white back surface-protective material film viewed through spaces between a plurality of photovoltaic cells looks like white-trimmed edge portions so that a surface of a photovoltaic cell panel tends to have an appearance with geometrical patterns which is considered to be improper for installing in scenic zones. For this reason, depending upon installation places of the photovoltaic cells, it will be required that the back surface-protective material film for photovoltaic cells is a film having not a white color but a black color or the other deep color tone. However, there are conventionally known no specific polyester films having a black color or the other deep color cone which are excellent in wet heat-resistant adhesion property to EVA or PBV.

PRIOR ART DOCUMENTS

Patent Documents

Patent Document 1: Japanese Patent Application Laid-Open (KOKAI) No. 2006-152013

SUMMARY OF THE INVENTION

Problems to be Solved by the Invention

The present invention has been accomplished to solve the above conventional problems. An object of the present invention is to provide a polyester film for a protective material for a backsheet of photovoltaic cells in which a colored film is used as a base material film thereof, and which is excellent in hydrolysis resistance and can exhibit an excellent wet heat-resistant adhesion property to sealing resins such as EVA and PVB used as a sealing material for photovoltaic cells by forming a coating layer thereon.

Means for Solving Problems

As a result of the present inventors' earnest study, it has been found that the above problems can be readily solved by using a polyester film having a specific structure. The present invention has been attained on the basis of this finding.
That is, in an aspect of the present invention, there is provided a polyester film for a protective material for a backsheet of photovoltaic cells, comprising a polyester film having a terminal carboxyl group content of not more than 26 equivalents/t and comprising a color pigment, and a coating layer formed on at least one surface of the polyester film which comprises a polyurethane having a polycarbonate skeleton or a polyether skeleton, and a crosslinking agent.

EFFECT OF THE INVENTION

The polyester film for a protective material for a backsheet of photovoltaic cells according to the present invention comprises a colored film having a black color or a deep color as a base film. Therefore, when the polyester film is applied to a photovoltaic cell panel, geometric patterns appearing on the surface of the panel can be prevented from becoming noticeable. Thus, even when the photovoltaic cell panel is installed in scenic zones, occurrence of any unnatural feel can be avoided. In addition, the polyester film of the present invention comprises a base film having an excellent hydrolysis resistance and further can exhibit an excellent wet heat-resistant adhesion property to a sealing resin such as EVA and PVB used as a sealing material for photovoltaic cells by providing a coating layer thereon. Therefore, the polyester film for a protective material for a backsheet of photovoltaic cells according to the present invention has a high industrial value.

PREFERRED EMBODIMENTS FOR CARRYING OUT THE INVENTION

The present invention has been accomplished based on such a technical concept that only when a polyester film as a base material has an excellent hydrolysis resistance even under high-temperature and high-humidity conditions and at the same time, a coating layer formed on the polyester film for improving an adhesion property of the film also has a good hydrolysis resistance, the resulting laminated film can provide an easy-bonding film having a good hydrolysis resistance. When any of the polyester film as the base material and the coating layer formed thereon is deteriorated in hydrolysis resistance, the hydrolysis resistance of the resulting easy-bonding film tends to be strongly influenced by anyone of the polyester film and the coating layer whichever is more deteriorated in hydrolysis resistance, and therefore tends to become insufficient. For this reason, in order to obtain a polyester film having an excellent hydrolysis resistance as an easy-bonding film, it is inevitably required that the base material film and the coating layer both are excellent in hydrolysis resistance. On the basis of the above technical concept, the present invention is sequentially explained in detail below with respect to the polyester film as a base material and the coating layer.
The polyester film used as a base material in the present invention is a polyester film comprising a color pigment. The polyester film is required to have a terminal carboxyl group content of not more than 26 equivalents/t.
The polyester used as a base material for the film according to the present invention means an aromatic polyester obtained by polycondensing an aromatic dicarboxylic acid and an aliphatic glycol. Examples of the aromatic dicarboxylic acid include terephthalic acid, isophthalic acid and 2,6-naphthalenedicarboxylic acid. Examples of the aliphatic glycol include ethylene glycol, diethylene glycol and 1,4-cyclohexanedimethanol. Among these polyesters, preferred is polyethylene terephthalate (PET) from the viewpoint of a good balance between costs and performance. Thus, in the present invention, a polyethylene terephthalate film may be suitably used as the polyester film.

The polyester raw materials for the polyester film used as a base material in the present invention may comprise a compound of a metal such as antimony, titanium and germanium which has been frequently used as a polymerization catalyst usually upon polymerization for production of polyesters. However, when the amount of the polymerization catalyst used is excessively large, the polyester tends to suffer from decomposition reaction when melted to form a film therefrom, which tends to result in high terminal carboxylic acid concentration owing to reduction in molecular weight, etc., and deteriorated hydrolysis resistance of the resulting film. On the other hand, when the amount of the polymerization catalyst used is excessively small, the polymerization reaction rate tends to be lowered, so that the polymerization time tends to be prolonged and the terminal carboxylic acid concentration of the obtained polyester tends to be increased, which tends to result in deteriorated hydrolysis resistance of the resulting film. For the above reasons, in the present invention, the amount of antimony used is usually in the range of 50 to 400 ppm and preferably 100 to 350 ppm; the amount of titanium used is usually in the range of 1 to 20 ppm and preferably 2 to 15 ppm; and the amount of germanium used is usually in the range of 3 to 50 ppm and preferably 5 to 40 ppm. These polymerization catalysts may be used alone or in combination of any two or more thereof.

The polyester film used as a base material in the present invention is required to comprise a color pigment. The color pigment as used herein means a pigment having a color other than a white color. The polyester film is colored by the color pigment to exhibit a black color or a deep color. As the color pigment, there may be used known inorganic pigments and organic pigments. Examples of the color inorganic pigments include red pigments such as red iron oxide, molybdenum red and cadmium red; orange pigments such as chrome orange and chrome vermilion; blue pigments such as ultramarine blue, Prussian blue, cobalt blue and cerulean blue; green pigments such as chromium oxide, viridian, emerald green and cobalt green; yellow pigments such as chrome yellow, cadmium yellow, yellow iron oxide and titanium yellow; violet pigments such as manganese violet and mineral violet; and black pigments such as black iron oxide. Further examples of the black pigments include carbon blacks (such as channel black, furnace black, acetylene black and thermal black), carbon nanotubes (single layer and multi-layer) and aniline black. Examples of the color organic pigments include condensed azo pigments, phthalocyanine-based pigments, quinacridone-based pigments, oxazine-based pigments, xanthene-based pigments, isoindolinone-based pigments, quinophthalone-based pigments and anthraquinone-based pigments. Among these pigments, the inorganic pigments, carbon blacks and carbon nanotubes are preferable to the organic pigments because the former materials tend to be more excellent in heat resistance upon melt-molding of the polyester and light resistance when used in the outdoors as compared to the latter organic pigments. Further, among these materials, from the viewpoints of color tone similar to that of photovoltaic cells, tinting strength and economy of the color pigments and no significant influence on the polyester such as accelerated decomposition of the polyester, carbon blacks are more suitably used in the polyester film for a protective material for a backsheet of photovoltaic cells according to the present invention.

The color pigments may be used solely, but may be in combination of any two or more kinds thereof for the purpose of well controlling a color tone thereof, etc. The particle diameter of the above color pigment may vary depending upon kinds of particles thereof, and may be selected from the range of usually 0.01 to 10 $\mu$m and preferably 0.02 to 5 $\mu$m. In particular, the hiding power of the color pigment is generally enhanced as the average particle diameter thereof is reduced, and becomes maximum when the average particle diameter is about 1/2 time a wavelength of light irradiated thereto. When the average particle diameter of the color pigment is further reduced, the hiding power thereof tends to be rapidly decreased and exhibit an increased transparency. In view of these tendencies, the average particle diameter of the color pigment is preferably about 0.05 to about 2 $\mu$m in order to enhance a hiding power thereof.

The content of the color pigment in the polyester film is preferably not less than 0.05 g per 1 m$^2$ of the polyester film, and more preferably not less than 0.1 g per 1 m$^2$ of the polyester film. When the content of the color pigment in the polyester film is less than 0.05 g per 1 m$^2$ of the polyester film, the resulting film tends to be insufficient in tinting property and hiding property, thereby failing to attain the aimed effects of the present invention. The upper limit of the content of the color pigment in the polyester film is not particularly provided. However, when the content of the color pigment in the polyester film is more than 15 g per 1 m$^2$ of the polyester film, the hiding power of the resulting film is already saturated, and therefore the use of such a large amount of the color pigment tends to be disadvantageous in view of costs. In addition, since the amount of the color pigment added to the polyester film becomes excessive based on the weight of the polyester constituting the film, there tends to arise the drawbacks such as deterioration in mechanical strength of the polyester film.

In addition to the above color pigment added to the polyester film, for the purpose of controlling a color tone of the resulting film, a white pigment may be added in combination therewith. Examples of the above white pigment include titanium dioxide, zinc oxide, zinc sulfide and barium sulfate. The average particle diameter of the white pigment may be selected from the range of usually 0.01 to 10 $\mu$m and preferably 0.02 to 5 $\mu$m. The amount of the white pigment added may be controlled such that the lightness (L*) of the film obtained after controlling a color tone thereof is preferably not more than 40% and more preferably not more than 30% so as to approach to a color tone (lightness) of the photovoltaic cells.

The polyester film of the present invention may be further compounded with particles, in addition to the above color pigment and white pigment, for the purpose of mainly imparting an easy-slipping property to the film. The particles to be compounded in the film are not particularly limited, and any particles can be used as long as they are capable of imparting an easy-slipping property to the film. Specific examples of the particles to be compounded in the film include particles of silica, calcium carbonate, magnesium carbonate, barium carbonate, calcium sulfate, silicon oxide, kaolin, aluminum oxide and the like. In addition, there may also be used refractory organic particles as described in Japanese Patent Publication (KOKOKU) No. 59-5216(1984), Japanese Patent Application Laid-Open (KOKAI) No. 59-217755 (1984), etc. Examples of the other refractory organic particles include particles of heat-cured urea resins, heat-cured phenol resins, heat-cured epoxy resins, benzoguanamine resins or the like. Further, there may also be used deposited particles produced by precipitating or finely dispersing a part of the metal compounds such as the catalyst during the step for production of the polyester.

The particles used for imparting an easy-slipping property to the film preferably have an average particle diameter of usually 0.1 to 10 $\mu$m. The amount of the particles added may be selected from the range of 0.005 to 5.0% by weight.

The method of adding the above color pigment or easy-slipping property-imparting particles to the polyester film is not particularly limited, and any conventionally known methods may be suitably used in the present invention. For example, the pigment or particles may be added in any optional stage of the production process of a polyester as the raw material. The pigment or particles are preferably added in the esterification stage or after completion of the transesterification reaction to allow a polycondensation reaction of the polyester to proceed. In addition, there may also be used the method of kneading a slurry prepared by dispersing the particles in ethylene glycol or water with the polyester raw material using a vented twin-screw extruder, a method of kneading the dried particles with the polyester raw material, and the like. In particular, in the case where the polyester film comprises the color pigment or white pigment, there is preferably used the method in which the color pigment or white pigment is added to the polyester raw material to prepare a high-concentration master batch, and the master batch is diluted upon use when forming the film therefrom from the viewpoint of reducing a terminal carboxyl group content in the polyester constituting the film.

Meanwhile, in the polyester film of the present invention, in addition to the above color pigment or easy-slipping property-imparting particles, various conventionally known additives such as an antioxidant, a thermal stabilizer, a lubricant, an antistatic agent, a fluorescent brightener and a dye may be added thereto, if required. Also, for the purpose of enhancing a light resistance of the polyester film, an ultraviolet absorber may be added thereto in an amount of 0.01 to 5 parts by weight based on the weight of the polyester. Examples of the ultraviolet absorber include triazine-based compounds, benzophenone-based compounds and benzoxazinone-based compounds. Among these ultraviolet absorbers, the benzoxazinone-based compounds are especially preferably used. Also, in the case where the film itself has a multilayer structure having three or more layers, there may also be suitably used the method in which these ultraviolet absorbers are added to an intermediate layer. As a matter of course, these ultraviolet absorbers or additives may be prepared in the form of a high-concentration master batch, and may be diluted upon use when forming the film.

In the present invention, using two or three or more melting extruders, it is possible to produce a laminated film having two layers or three or more layers by a so-called co-extrusion method. As the layer structure of the resulting laminated film, there may be mentioned a layer structure of A/B or A/B/A using a raw material A and a raw material B, a layer structure of A/B/C further using a raw material C, and the other layer structures having a further increased number of layers. The polyester layer in which the color pigment is to be incorporated may be optionally selected. That is, the color pigment may be incorporated either in an intermediate layer or in one or both of surface layers, or may be incorporated in both of the surface and intermediate layers.

However, in the case where a large amount of the color pigment is added to a polyester layer in the laminated polyester film so that the concentration of the color pigment in the polyester layer becomes high, it is preferred that no color pigment is added to a surface layer of the film onto which the below-mentioned coating layer is laminated, or in the case where the color pigment is added to the surface layer of the film, the amount of the color pigment added to the surface layer of the film is preferably controlled so as to be lower than that of another polyester layer in which the color pigment is present at a high concentration, and the color pigment is preferably added in a large amount to the intermediate layer or the surface layer on an opposite surface of the film which are free from contact with the coating layer. The above measures are desirable from the viewpoint of maintaining adhesion between the coating layer and the polyester film for a long period of time.

In the film according to the present invention, it is required that the terminal carboxylic acid content in the film is not more than 26 equivalents/t as measured with respect to a whole portion of the film (except for the coating layer and the color pigment) by the below-mentioned method, and the terminal carboxylic acid content is preferably not more than 24 equivalents/t. When the terminal carboxylic acid content in the film is more than 26 equivalents/t, the polyester film tends to be deteriorated in hydrolysis resistance. The hydrolysis resistance of the polyester film is a property associated with the whole portion of the film. In the present invention, it is required that the terminal carboxylic acid content in the polyester constituting the film as a whole lies within the above-specified range. On the other hand, in view of the hydrolysis resistance as required in the present invention, the lower limit of the terminal carboxylic acid content in the polyester is not particularly limited, and is usually about 10 equivalents/t from the viewpoints of attaining a high polycondensation reaction efficiency and preventing hydrolysis or thermal decomposition of the polyester upon melt-extrusion step, etc.

In the present invention, the terminal carboxylic acid content in the polyester film may be adjusted to the specific range by the following methods. That is, in the melt-extrusion step of polyester chips during the process for production of the film, there may be used a) the method of possibly avoiding occurrence of hydrolysis of the polyester chips owing to water contained therein, b) the method of possibly shortening a retention time of the polyester in an extruder or a melt line, or the like.

As a specific example of the method a), there may be used a method of previously drying the raw material to a sufficient extent such that the water content therein is controlled to not more than 50 ppm and preferably not more than 30 ppm in the case of using a single-screw extruder, a method of providing a vent port on a twin-screw extruder to maintain an inside of the extruder at a reduced pressure of not more than 40 hPa, preferably not more than 30 hPa and more preferably not more than 20 hPa, etc.

As a specific example of the method b), there is preferably used the method in which a retention time of the polyester from charging of the raw material into an extruder up to initiation of discharging a molten sheet from a die is preferably adjusted to 20 min or shorter and more preferably 15 min or shorter.

Also, it is important that the film formation process is conducted using a polyester having a low terminal carboxylic acid content as a raw material to obtain a polyester film whose terminal carboxylic acid content lies within the specific range. More specifically, the terminal carboxylic acid content of the raw polyester is preferably not more than 20 equivalents/t and more preferably not more than 15 equivalents/t as a total amount thereof. As the method of reducing the terminal carboxylic acid content in the raw polyester, there may be adopted any conventionally known methods such as the method of increasing a polymerization efficiency, the method of increasing a polymerization rate, the method of suppressing a decomposition rate, the method of using combination of melt-polymerization and solid state polymerization, etc. These methods may be accomplished, for example, by the method of shortening a polymerization time, the method of increasing an amount of a polymerization catalyst used, the method of using a high-activity polymerization catalyst, the method of reducing a polymerization temperature, etc. In the case of using combination of the melt polymerization and the solid state polymerization, the polyester obtained after the melt polymerization is formed into chips and then subjected to solid state polymerization under reduced pressure while heating or in an inert gas flow such as nitrogen in a temperature range of 180 to 240°C. The resulting polyester preferably has an intrinsic viscosity of not less than 0.55 dl/g and more preferably 0.60 to 0.90 dl/g. Also, upon production of the film, when using a reclaim raw material obtained through the melting step, the terminal carboxylic acid content of the resulting film tends to be increased. Therefore, in the present invention, it is preferred that none of such a reclaim raw material is compounded, or even when compounded, the amount of the reclaim raw material compounded is preferably not more than 20 parts by weight.

The phosphorus element content in the polyester film as the base material used in the present invention is preferably in the range of 0 to 170 ppm and more preferably 0 to 140 ppm as measured with respect to a whole portion of the film and detected in analysis using the below-mentioned fluorescent X-ray analyzer. The phosphorus element content in the polyester film may be 0 ppm. The phosphorus element is usually derived from phosphoric acid compounds added as a catalyst component upon production of the polyester. In the present invention, when the phosphorus element content satisfies the above specific range, it is possible to impart a good hydrolysis resistance to the film. When the phosphorus element content is excessively large, the film tends to suffer from accelerated hydrolysis owing to the phosphoric acid compounds. The hydrolysis resistance of the polyester film is a property associated with a whole portion of the film. Therefore, in the present invention, it is preferred that the phosphorus content of the polyester constituting the film as a whole lie within the above-specified range.

Examples of the phosphoric acid compound include known compounds such as phosphoric acid, phosphorous acid or esters thereof, phosphonic acid compounds, phosphinic acid compounds, phosphonous acid compounds, and phosphinous acid compounds. Specific examples of the phosphoric acid compound include orthophosphoric acid, monomethyl phosphate, dimethyl phosphate, trimethyl phosphate, monoethyl phosphate, diethyl phosphate, triethyl phosphate, ethyl acid phosphate, monopropyl phosphate, dipropyl phosphate, tripropyl phosphate, monobutyl phosphate, dibutyl phosphate, tributyl phosphate, monoamyl phosphate, diamyl phosphate, triamyl phosphate, monohexyl phosphate, dihexyl phosphate and trihexyl phosphate.

In the followings, the process for producing the polyester film according to the present invention is more specifically described. However, the present invention is not particularly limited to the following embodiments, and the other variations and modifications are possible as long as they satisfy the subject matter of the present invention.

The polyester film having a single layer structure may be produced using a single melt extruder. When the polyester film has a multi-layer structure, according to the laminated layer construction of the polyester film, the necessary number of melt extruders may be used together with feed blocks or multilayer multi-manifold dies for laminating the raw materials extruded from the melt extruders. The polyester chips dried by known methods are fed to a single-screw extruder or the undried polyester chips are fed to a twin-screw extruder having a vent port connected to a reduced pressure system, and heated and melted at a temperature not lower than a melting point of the respective polymers. In this case, there may be used the method of passing the polyester chips through known suitable filters in order to remove foreign matters from the polyester chips, and/or the method of reducing pulsation of a molten polymer using a gear pump. Next, the molten polymers are extruded from the respective dies onto a rotary chilled drum. The thus extruded sheet is rapidly cooled and solidified on the rotary chilled drum such that the temperature of the sheet is decreased to not higher than a glass transition temperature thereof, thereby obtaining a substantially amorphous unoriented sheet. In this case, in order to enhance a flatness of a surface of the sheet, it is preferred to enhance adhesion between the sheet and the rotary chilled drum. For this purpose, in the present invention, an electrostatic pinning method and/or a liquid coating adhesion method are preferably adopted.

In the present invention, the thus obtained sheet is subjected to biaxial drawing to form a film. The drawing conditions are described more specifically. The above-obtained unoriented sheet is preferably drawn at a temperature of 70 to 145°C and a draw ratio of 2 to 6 times in a longitudinal direction (MD direction) thereof to obtain a longitudinally monoaxially oriented film. Then, the thus obtained monoaxially oriented film is drawn at a temperature of 90 to 160°C and a draw ratio of 2 to 6 times in a lateral direction (TD direction) thereof. The resulting oriented sheet is then heat-treated at a temperature of 160 to 240°C for a period of 1 sec to 600 sec. Alternatively, using a simultaneous biaxial drawing machine, the sheet is drawn in longitudinal and lateral directions thereof at the same time at a temperature of 70 to 160°C within the range of an area ratio of 5 to 20 times, and then subjected to the heat-setting under the same conditions as described above.

Further, upon the heat-setting, in the heat-setting maximum temperature zone and/or a cooling zone located at an outlet of the heat-setting zone, the resulting film is preferably subjected to relaxation by 0.1 to 20% in longitudinal and/or lateral directions thereof. In addition, the resulting film may be subjected to longitudinal drawing and lateral drawing again, if required.

In the case where the below-mentioned coating layer is applied by an in-line coating method, at the time at which the longitudinal drawing is completed, the coating treatment is carried out, and after the resulting coating layer is dried, the polyester film is subjected to lateral drawing.

Next, the coating layer provided in the film of the present invention is described.

It is required that the polyester film for a protective material for a backsheet of photovoltaic cells according to the present invention is provided on at least one surface thereof with a coating layer which comprises a polyurethane having at least one of a polycarbonate skeleton and a polyether skeleton and a crosslinking agent in order to impart an adhesion property less deteriorated owing to hydrolysis between the polyester film and various sealing resins for photovoltaic cells such as EVA, PVB, ethylene-methyl acrylate copolymers (EMA), ethylene-ethyl acrylate copolymers (EEA) and ethylene-$\alpha$-olefin copolymers.

The polyurethane having a polycarbonate skeleton or a polyether skeleton may be produced by using a compound having a polycarbonate skeleton or a polyether skeleton as a polyol. Meanwhile, the polyurethane may comprise both of a polycarbonate skeleton and a polyether skeleton at the same time.

The polycarbonate polyol used for production of the polyurethane constituting the coating layer may be obtained, for example, by reacting diphenyl carbonate, dialkyl carbonate, ethylene carbonate or phosgene with a diol. Examples of the diol include ethylene glycol, 1,2-propylene glycol, 1,3-propylene glycol, 1,2-butanediol, 1,3-butanediol, 1,4-butanediol, 1,5-pentanediol, 1,6-hexanediol, 1,4-cyclohexanediol, 1,4-cyclohexane dimethanol, 1,7-heptanediol, 1,8-octanediol, 1,9-nonanediol, 1,10-decanediol, neopentyl glycol, 3-methyl-1,5-pentanediol and 3,3-dimethylol heptane. Among these polyol compounds, the polycarbonate polyols produced using 1,6-hexanediol are preferred from the viewpoints of a good industrial availability, an enhanced adhesion property and a good hydrolysis resistance.

The polycarbonate polyols preferably have a number-average molecular weight of 300 to 5000 in terms of polystyrene as measured by gel permeation chromatography (GPC).

Examples of the polyether polyol used for production of the polyurethane constituting the coating layer include polyoxyethylene polyols (such as polyethylene glycol), polyoxypropylene polyols (such as polypropylene glycol), polyoxytetramethylene polyols (such as polytetramethylene ether glycol), and copolymerized polyether polyols (such as block copolymers or random copolymers of polyoxyethylene glycol and polyoxypropylene glycol, etc.). Among these polyether polyols, polytetramethylene glycol is preferred from the viewpoint of not only an enhanced adhesion property but also a good hydrolysis resistance.

The polyether polyols preferably have a number-average molecular weight of 300 to 5000 in terms of polyethylene glycol as measured by gel permeation chromatography (GPC).

The polyurethane produced by using the above polycarbonate polyols or polyether polyols are more excellent in hydrolysis resistance than those polyurethanes produced using polyester polyols as another generally used polyol.

These polycarbonate polyols or polyether polyols may be respectively used alone or in combination of any two or more thereof. The polycarbonate polyols and the polyether polyols may also be used in combination with each other as described above.

As a polyisocyanate used for production of the polyurethane constituting the coating layer, there may be used conventionally known aliphatic, alicyclic or aromatic polyisocyanates, etc.

Specific examples of the aliphatic polyisocyanates include tetramethylene diisocyanate, dodecamethylene diisocyanate, hexamethylene diisocyanate, 2,2,4-trimethylhexamethylene diisocyanate, 2,4,4-trimethylhexamethylene diisocyanate, 2-methyl pentane-1,5-diisocyanate, and 3-methyl pentane-1,5-diisocyanate.

Specific examples of the alicyclic polyisocyanates include isophorone diisocyanate, hydrogenated xylylene diisocyanate, hydrogenated diphenylmethane-4,4'-diisocyanate, hydrogenated biphenyl-4,4'-diisocyanate, 1,4-cyclohexane diisocyanate, hydrogenated tolylene diisocyanate, 1,3-bis(isocyanatomethyl)cyclohexane, and 1,4-bis(isocyanatomethyl)cyclohexane.

Specific examples of the aromatic polyisocyanates include tolylene diisocyanate, 2,2'-diphenylmethane diisocyanate, 2,4'-diphenylmethane diisocyanate, 4,4'-diphenylmethane diisocyanate, 4,4'-diphenyldimethylmethane diisocyanate, 4,4'-dibenzyl diisocyanate, 1,5-naphthylene diisocyanate, xylylene diisocyanate, 1,3-phenylene diisocyanate, and 1,4-phenylene diisocyanate.

Also, these polyisocyanates may be used alone or in the form of a mixture of any two or more thereof.

Examples of the chain extender, etc., include ethylene glycol, propylene glycol, butanediol, diethylene glycol, neopentyl glycol, trimethylol propane, hydrazine, ethylenediamine, diethylenetriamine, isophorone diamine, 4,4'-diaminodiphenylmethane, 4,4'-diaminodicyclohexylmethane and water.

The polyurethane having at least one of a polycarbonate structure or a polyether structure which is used in the coating layer in the present invention may be in the form of a dispersion or solution prepared using an organic solvent as a medium therefor. However, the polyurethane is preferably used in the form of a dispersion or solution prepared using water as the medium. As the polyurethane in the form of a dispersion or solution in water, there may be used a forced emulsification-type polyurethane prepared using an emulsifier, a self-emulsifiable type or a water-soluble type polyurethane prepared by introducing a hydrophilic group into a polyurethane resin, or the like.
In particular, the self-emulsifiable type polyurethane prepared by introducing an ionic group into a skeleton of the polyurethane resin for forming an ionomer thereof is preferably used because it is excellent in liquid storage stability of a coating solution as well as water resistance, transparency and adhesion property of the resulting coating layer.

In addition, examples of an anionic group as the ionic group to be introduced into the skeleton of the polyurethane resin include a carboxylate group, a sulfonate group, a phosphate group and a phosphonate group. Examples of a cationic group as the ionic group include a quaternary ammonium group, etc. Specific examples of the carboxylate group as the anionic group include ammonium salts or lower amine salts of dimethylol propionic acid, dimethylol butanoic acid, bis-(2-hydroxyethyl)propionic acid, bis-(2-hydroxyethyl)butanoic acid, trimellitic acid-bis(ethylene glycol) ester, etc. As the quaternary ammonium group as the cationic group, there may be suitably used quaternarized products of N-alkyl dialkanol amines such as N-methyl diethanol amine and N-ethyl diethanol amine, etc. Among these ionic groups, especially preferred are carboxylate groups whose counter ion is ammonia or an organic amine having a boiling point of not higher than 150°C such as triethyl amine, from the viewpoints of a high reactivity with the below-mentioned oxazoline-based crosslinking agent or carbodiimide-based crosslinking agent and an enhanced crosslinking density of the resulting coating layer.

As the method of introducing the ionic group into the urethane resin, there may be used various methods which may be conducted at the respective stages of the polymerization reaction. For example, there may be used the method in which a resin having an ionic group is used as a comonomer component upon synthesis of a prepolymer, the method in which a component having an ionic group is used as one of components such as a polyol, a chain extender and the like.

In the coating layer provided in the film of the present invention, it is required that a crosslinking agent is used in combination with the above polyurethane for the purpose of imparting a heat resistance, a heat-resistant adhesion property, a moisture resistance and an antiblocking property to the resulting coating layer. The crosslinking agent is preferably either water-soluble or water-dispersible. More specifically, it is preferred that the coating layer comprises at least one compound selected from the group consisting of methylolated or alkoxymethylolated melamine-based compounds, benzoguanamine-based compounds, urea-based compounds, acrylamide-based compounds, epoxy-based compounds, isocyanate-based compounds, carbodiimide-based compounds, oxazoline-based compounds, silane coupling agent-based compounds and titanium coupling agent-based compounds. Among these crosslinking agents, especially preferred are oxazoline-based compounds and carbodiimide-based compounds because they are in the form of a polymer by themselves and therefore capable of considerably enhancing a heat-resistant and moisture-resistant adhesion property of the coating layer. Examples of such an oxazoline-based crosslinking agent include industrially available products such as "EPOCROS (registered trademark)" (tradename) produced by Nippon Shokubai Co., Ltd. Examples of such a carbodiimide-based crosslinking agent include industrially available products such as "CARBODILITE (registered trademark)" (tradename) produced by Nisshinbo Chemical Inc. The crosslinking agent may be added to the coating layer in such an amount that the weight ratio of the crosslinking agent to the polyurethane in the coating layer is 10:90 to 90:10 and preferably 20:80 to 80:20.

In the coating layer provided in the film of the present invention, the total amount of the above-mentioned polyurethane and crosslinking agent components is preferably not less than 50% by weight and more preferably not less than 75% by weight. In addition to these resin components, the other additional resins may be further added to the coating layer. Examples of the other additional resins which may be added to the coating layer include polyester-based resins, acryl-based resins, polyvinyl-based resins and polyester polyurethane resins. However, the polyester-based resins and the polyester polyurethane resins tend to be frequently deteriorated in hydrolysis resistance. Therefore, none of these resins are added to the coating layer, or if added, the amount of these resins added is preferably controlled to less than 10% by weight.

Further, in the present invention, in order to prevent occurrence of blocking in the coating layer and imparting a slip property to the coating layer, it is possible to add fine particles to the coating layer. Examples of the fine particles include inorganic particles such as particles of silica, alumina and metal oxides, and organic particles such as crosslinked polymer particles. The particle size of the fine particles is not more than 150 nm and preferably not more than 100 nm, and the amount of the fine particles added to the coating layer is preferably selected from the range of 0.5 to 10% by weight.

In addition to the above-mentioned components, the coating layer may further comprise the other components, if required. Examples of the other components include surfactants, defoaming agents, coatability improvers, thickening agents, antioxidants, antistatic agents, ultraviolet absorbers, foaming agents, dyes and pigments. These additives may be used alone or in combination of any two or more thereof.

As described above, the coating layer provided in the film of the present invention is preferably formed by applying a coating solution prepared using water as a main medium onto a polyester film. The polyester film to which the coating solution is to be applied may be previously biaxially drawn. However, there is preferably used a so-called in-line coating method in which the polyester film is drawn in at least one direction after applying the coating solution thereto, and then heat-set. According to the in-line coating method, the polyester film and the coating layer can be heat-set at an elevated temperature usually as high as not lower than 200°C at the same time, so that the heat crosslinking reaction of the coating layer is allowed to proceed sufficiently, and the adhesion between the coating layer and the polyester film can be enhanced.

In addition, the coating solution may comprise, in addition to water, one or more organic solvents having a compatibility withy water in an amount of usually not more than 20% by weight for the purposes of enhancing a dispersibility and a storage stability thereof as well as improving a coatability thereof and properties of the resulting coating film.

As the method of applying the coating solution onto the polyester film as the base material, there may be used optional conventionally known coating methods. Specific examples of the coating methods include a roll coating method, a gravure coating method, a micro-gravure coating method, a reverse coating method, a bar coating method, a roll brush coating method, a spray coating method, an air knife coating method, an impregnation coating method, a curtain coating method and a die coating method. These coating methods may be used alone or in combination of any two or more thereof.

The coating amount of the coating layer as a dried film finally obtained after drying and solidification or after subjected to biaxial drawing and heat-setting, etc., is preferably in the range of 0.005 to 1.0 g/m$^2$ and more preferably 0.01 to 0.5 g/m$^2$. When the coating amount is less than 0.005 g/m$^2$, the resulting coating layer tends to be insufficient in adhesion property. When the coating amount is more than 1.0 g/m$^2$, the effect of enhancing the adhesion property of the coating layer is already saturated, and on the contrary, the resulting film rather tends to suffer from drawbacks such as blocking.

In the present invention, the coating layer may be provided on only one surface of the polyester film or may be provided on both surfaces thereof. In addition, the above coating layer comprising the polyurethane having at least one of a polycarbonate skeleton and a polyether skeleton and the crosslinking agent may be provided on one surface of the polyester film, and the other coating layer may be provided on the opposite surface of the polyester film. As the other coating layer formed on the opposite surface of the polyester film, there may be mentioned, for example, an antistatic coating layer, an easy-bonding coating layer exhibiting an easy-bonding property to a vapor-deposited layer formed of metals or metal oxides, and an easy-bonding coating layer exhibiting an easy-bonding property to known adhesives.

EXAMPLES

The present invention is described in more detail below by the following Examples and Comparative Examples. However, these Examples are only illustrative and not intended to limit the present invention thereto, and other variations and modifications are possible unless they depart from the scope of the present invention. Meanwhile, the methods for measuring and evaluating various properties of the film are as follows.

(1) Terminal carboxylic acid content (equivalent/t):

The terminal carboxylic acid content was measured by a so-called titration method. More specifically, a phenol red indicator was added to a solution prepared by dissolving the polyester in benzyl alcohol, and the resulting solution was titrated with a water/methanol/benzyl alcohol solution of sodium hydroxide. When the film was provided with a coating layer, in order to eliminate adverse influence of the coating layer on the measurement, the coating layer was washed out and removed using an abrasive-containing cleanser. Thereafter, the thus treated film was sufficiently rinsed with ion-exchanged water, dried, and then subjected to the same measurement as described above. In addition, in the case where the polyester film comprised a color pigment or a white pigment, these pigments as a benzyl alcohol-insoluble component were removed from the polyester film by a centrifugal precipitation method, and the resulting pigment-free material was subjected to titration to determine a terminal carboxylic acid content (equivalent/t) based on the polyester component.

(2) Quantitative determination of elements derived from catalyst:

Using a fluorescent X-ray analyzer "Model No.: XRF-1500" manufactured by Shimadzu Corp., the amounts of respective elements in the film were determined under the following conditions as shown in Table 1. In the case where the film to be measured was in the form of a laminated film, the laminated film was melted and then molded into a disk shape, and the disk-shaped molded product was subjected to the measurement of contents of the elements based on the whole portion of the film. Further, in the case where the film was provided with a coating layer, in order to eliminate adverse influence of the coating layer on the measurement, the coating layer was washed out and removed using an abrasive-containing cleanser. Thereafter, the thus treated film was sufficiently rinsed with ion-exchanged water, dried, and then subjected to the same measurement as described above. Meanwhile, in the above method, the detection limit was usually about 1 ppm.

Table 1

|  | Sb | Ge | Ti | P |
|---|---|---|---|---|
| X-ray tube target | Rh4.0kW | Rh4.0kW | Rh4.0kW | Rh4.0kW |
| Voltage (kV) | 40 | 40 | 40 | 40 |
| Current (mA) | 95 | 95 | 95 | 95 |
| Analyzing crystal | LiF | LiF | LiF | Ge |
| Detector | FPC | SC | SC | FPC |
| $2\theta$ (deg) | 117.34 | 36.33 | 86.14 | 141.03 |
| Measuring time (sec) two-point background; 20 sec for each | 40.0 | 40.0 | 40.0 | 40.0 |

(3) Intrinsic viscosity:

One gram of a sample to be measured was accurately weighed, and dissolved in a mixed solvent comprising phenol and tetrachloroethane at mixing ratio (phenol/tetrachloroethane) of 50/50 (parts by weight) to prepare a solution having a concentration (c) of 0.01 $g/cm^3$. The relative viscosity $\eta r$ of the thus prepared solution relative to the solvent was measured at 30°C to thereby determine an intrinsic viscosity $[\eta]$ thereof.

(4) Retention rate of wet heat-resistant elongation at break of film:

Using a personal pressure cooker "PC-242HS-E" manufactured by Hirayama Manufacturing Corp., the film was treated in an atmosphere of 120°C and 100% RH for 35 hr. Next, after the film was conditioned with respect to temperature and humidity thereof in an atmosphere of 23°C and 50% RH for 24 hr, the elongation at break of the film in a film-forming direction (MD direction) of the film as mechanical properties thereof was measured. The measurement of the elongation at break of the film was conducted using a universal tester "AUTOGRAPH" manufactured by Shimadzu Corp., under the conditions that the width of the sample was 15 mm; a distance between chucks was 50 mm; and an elastic stress rate was 200 mm/min. The retention rate (%) of the elongation at break between before and after the above treatment was calculated from the following formula (1), and the film was evaluated according to the following ratings.

$$\text{Retention rate of elongation at break} = (\text{elongation at break after treatment}) \div (\text{elongation at break before treatment}) \times 100 \qquad (1)$$

A: The retention rate was not less than 80%;
B: The retention rate was not less than 60% and less than 80%;
C: The retention rate was not less than 30% and less than 60%; and
D: The retention rate was less than 30%.

(5) Adhesion strength to EVA:

A polyester film was cut to prepare two small pieces each having a length of 300 mm and a width of 25 mm such that the longitudinal direction of each small piece was aligned with the MD direction. On the other hand, an EVA film was cut to prepare a small piece having a length of 50 mm and a width of 25 mm, and the small piece of the EVA film was interposed between the two small pieces of the polyester film such that a coating layer of each small piece of the polyester film faced to the small piece of the EVA film. The thus overlapped film pieces were laminated using a heat seal tester "TP-701-B" manufactured by Tester Sangyo Co., Ltd. The EVA film used in the above measurement was "485.00" (standard cured type; thickness: 0.5 mm) produced by Etimex GmbH, Germany, and the heat sealing was conducted at a temperature of 150°C under a pressure of 0.13 MPa for 20 min. In order to measure an adhesion strength of the polyester film to EVA, the 25 mm-width small piece of the polyester/EVA laminated film was cut to prepare a sample having a length of 300 mm and a width of 15 mm. The obtained sample was fitted to a tensile/bending tester "EZ Graph" manufactured by Shimadzu Corp., at end portions thereof where each polyester film small piece having a width of 15 mm was not laminated with the EVA film small piece. Successively, the polyester/EVA laminated film sample was separated into the respective film pieces at a peel angle of 180° and a peel speed of 100 mm/min to measure a force (adhesion strength) required for separating the respective film pieces of the polyester/EVA laminated film from each other. The measurement was conducted with respect to 10 samples, and the measurement results were classified into the following ratings on the basis of an average value of the measured adhesion strength values.
A: The adhesion strength was not less than 50 N/15 mm in width;
B: The adhesion strength was not less than 30 N/15 mm in width and less than 50 N/15 mm in width;
C: The adhesion strength was not less than 10 N/15 mm in width and less than 30 N/15 mm in width; and
D: The adhesion strength was less than 10 N/15 mm in width.

(6) Wet heat-resistant adhesion strength to EVA:

The 25 mm-width test piece of the polyester/EVA laminated film prepared in the above (5) was subjected to wet heat treatment in an atmosphere of 120°C and 100% RH for 35 hr in the same manner as used in the above (4). Next, the sample was conditioned with respect to temperature and humidity thereof in an atmosphere of 23°C and 50% RH for 24 hr, and then cut to prepare a measuring sample piece having a width of 15 mm. The measuring sample piece was subjected to the same measurement as used in the above (5) to determine an average value of the force (adhesion strength) required for separating the polyester/EVA laminated film into the respective film pieces. From the thus measured adhesion strength value and the adhesion strength before subjected to the wet heat treatment, the retention rate of the adhesion strength was calculated from the following formula, and the adhesion strength of the film was evaluated according to the following ratings.
Retention rate (%) of adhesion strength = (adhesion strength after wet heat treatment)/(adhesion strength before wet heat treatment)
A: The retention rate was not less than 70%;
B: The retention rate was not less than 50% and less than 70%;
C: The retention rate was less than 50%; and
D: The polyester film itself was considerably deteriorated, and suffered from breakage or damage.
(7) Adhesion property to polyvinyl butyral (PVB):

•Preparation of PVB sheet to be evaluated

Six parts by weight of powdery PVB (molecular weight: about 110,000; butyralization degree: 65 mol%; hydroxyl group content: about 34 mol%) and 4 parts by weight of tri(ethylene glycol)-bis-2-ethyl hexanoate (as a plasticizer) were mixed and swelled with 45 parts by weight of toluene, and then 45 parts by weight of ethanol were added to the resulting mixture to dissolve PVB therein. The obtained PVB solution was filled in a Teflon (registered trademark) petri dish, and dried in a hot air oven at 100°C for 1 hr to thereby obtain a PVB sheet having a thickness of about 0.4 mm.

•Evaluation for adhesion property:

The thus obtained PVB sheet was cut to prepare a sheet piece having a width of 1 cm and a length of 10 cm. The thus cut sheet piece was interposed between two films to be tested such that an easy-bonding surface of the respective films faced to the PVB sheet piece, and heat press-bonded together using a heat seal tester "TP-701" manufactured by Tester Sangyo Co., Ltd. The testing conditions used above were as follows.
Pressure: 0.13 MPa
Temperature: 140°C
Time: 3 min
The thus heat press-bonded laminated film was allowed to stand for cooling over day and night, and then it was attempted to peel off the heat press-bonded portions of the laminated film from each other by hands to evaluate an adhesion property thereof according to the following ratings.
A: Good adhesion strength (test films or PVB sheet were damaged upon peeling, or a strong peeling force was required for separating them from each other at a boundary therebetween);
B: Normal adhesion strength (the bonded portions were separated from each other at a boundary therebetween with a feel of a light resisting force);
C: Poor adhesion strength (the bonded portions were readily separated from each other at a boundary therebetween with substantially no feel of a resisting force); and
D: The polyester film itself was considerably deteriorated, and suffered from breakage.

(8) Wet heat-resistant adhesion property to PVB:

The test sample for evaluation of adhesion property prepared in the above (7) was subjected to wet heat treatment in an atmosphere of 85°C and 85% RH for 500 hr using a thermo-hygrostat "PR-2KP" manufactured by ESPEC Corp. The thus treated sample was taken out from the thermo-hygrostat and allowed to stand for cooling over day and night, and thereafter subjected to evaluation for an adhesion property thereof in the same manner as used in the above (7).
Next, the polyester raw materials used in the following Examples and Comparative Examples are explained.

<Method of producing polyester (1)>

A reaction vessel was charged with 100 parts by weight of dimethyl terephthalate and 60 parts by weight of ethylene glycol as starting materials as well as 0.09 part by weight of magnesium acetate tetrahydrate as a catalyst, and the reaction temperature in the reaction vessel was gradually raised from 150°C as a reaction initiation temperature while distilling off methanol as produced until reaching 230°C after 3 hr. After the elapse of 4 hr, the transesterification reaction was substantially terminated. The resulting reaction mixture was mixed with 0.04 part by weight of antimony trioxide, and the resulting mixture was subjected to polycondensation reaction for 4 hr. That is, in the above polycondensation reaction, the reaction temperature was gradually raised from 230°C and finally allowed to reach 280°C. On the other hand, the reaction pressure was gradually dropped from normal pressures and finally allowed to reach 40 Pa. After initiation of the reaction, the change in agitation power in the reaction vessel was monitored, and the reaction was terminated at the time at which the agitation power reached the value corresponding to an intrinsic viscosity of 0.61. The resulting polymer was withdrawn from the reaction vessel under application of a nitrogen pressure. As a result, it was confirmed that the thus obtained polyester (1) had an intrinsic viscosity of 0.61, and the terminal carboxylic acid content of the polymer was 32 equivalents/t.

<Method of producing polyester (2)>

The polyester (1) as a starting material was subjected to solid state polymerization at 220°C in vacuo to thereby obtain a polyester (2). As a result, it was confirmed that the thus obtained polyester (2) had an intrinsic viscosity of 0.81, and the terminal carboxylic acid content of the polymer was 7 equivalents/t.

<Method of producing polyester (3)>

The same procedure as used in the above method of producing the polyester (1) was conducted except that after completion of the transesterification reaction, 0.1 part by weight of amorphous silica particles having an average particle diameter of 2.6 $\mu$m in the form of a dispersion in ethylene glycol was added to the reaction solution, thereby obtain a polyester (3). As a result, it was confirmed that the thus obtained polyester (3) had an intrinsic viscosity of 0.61, and the terminal carboxylic acid content of the polymer was 28 equivalents/t.

<u><Method of producing polyester (4)></u>

The polyester (3) as a starting material was subjected to solid state polymerization at 220°C in vacuo to thereby obtain a polyester (4). As a result, it was confirmed that the thus obtained polyester (4) had an intrinsic viscosity of 0.73, and the terminal carboxylic acid content of the polymer was 10 equivalents/t.

<u><Method of producing polyester (5)></u>

The same procedure as defined in the above method of producing the polyester (1) was conducted except that after completion of the transesterification reaction, 0.047 part by weight of orthophosphoric acid (0.015 part by weight in terms of phosphorus element) was added to the reaction solution, and then 0.04 part by weight of antimony trioxide was added thereto, thereby obtain a polyester (5). As a result, it was confirmed that the thus obtained polyester (5) had an intrinsic viscosity of 0.61, and the terminal carboxylic acid content of the polymer was 31 equivalents/t.

<u><Method of producing polyester (6)></u>

The polyester (5) as a starting material was subjected to solid state polymerization at 220°C in vacuo to thereby obtain a polyester (6). As a result, it was confirmed that the thus obtained polyester (6) had an intrinsic viscosity of 0.73, and the terminal carboxylic acid content of the polymer was 10 equivalents/t.

<u><Method of producing carbon black master batch 1 (BMB-1)></u>

The above polyester (2) was charged into a vented twin-screw extruder, and then carbon black (oil furnace black having an average primary particle diameter of 70 nm) was fed into the extruder such that the content of the carbon black in the resulting mixture was 10% by weight, and the mixture was formed into chips, thereby obtaining a carbon black master batch (BMB-1).

<u><Method of producing phthalocyanine blue master batch (BMB-2)></u>

The above polyester (2) was charged into a vented twin-screw extruder, and then copper phthalocyanine blue (having an average primary particle diameter of 150 nm) was fed into the extruder such that the content of the copper phthalocyanine blue in the resulting mixture was 10% by weight, and the mixture was formed into chips, thereby obtaining a copper phthalocyanine blue master batch (BMB-2).

<u><Method of producing carbon black master batch 3 (BMB-3)></u>

The above polyester (6) was charged into a vented twin-screw extruder, and then carbon black (oil furnace black having an average primary particle diameter of 70 nm) was fed into the extruder such that the content of the carbon black in the resulting mixture was 10% by weight, and the mixture was formed into chips, thereby obtaining a carbon black master batch 3 (BMB-3).

<u><Method of producing titanium oxide master batch 1 (WMB-1)></u>

The above polyester (2) was charged into a vented twin-screw extruder, and then titanium oxide (anatase crystal type having a particle diameter of 0.3 $\mu$m) was fed into the extruder such that the content of titanium oxide in the resulting mixture was 50% by weight, and the mixture was formed into chips, thereby obtaining a white pigment master batch (WMB-1).

<u><Coating agents and formulation of coating agents></u>

The formulation of the coating agents for the coating layer are shown in Table 2 below. Meanwhile, the amounts of the respective components added as shown in Table 2 all represent "% by weight" in terms of a solid content. The coating agents used were as follows.

•U-1: A water dispersion of a polyurethane produced from polytetramethylene glycol having a number-average molecular weight of about 1000, dimethylol propionic acid and isophorone diisocyanate (counter ion of carboxylic acid: ammonia)

•U-2: A water dispersion of a polyurethane produced from a polycarbonate polyol of hexamethylene diol (having a number-average molecular weight of about 1000), dimethylol propionic acid and hydrogenated diphenyl methane-4,4'-diisocyanate (counter ion of carboxylic acid: triethylamine)

•U-3: "HYDRAN (registered trademark) AP-40F" (tradename) produced by DIC Corp., as a water dispersion of a polyester polyurethane produced from an aromatic polyester and an aliphatic diisocyanate

•E-1: "FINETEX (registered trademark) ES-670" (tradename) produced by DIC Corp., as a water dispersion of an aromatic polyester

•X-1: "EPOCROS (registered trademark) WS-500" (tradename) produced by Nippon Shokubai Co., Ltd., as an oxazoline-based water-soluble resin crosslinking agent

•X-2: "CARBODILITE (registered trademark) V-02-L2" (tradename) produced by Nisshinbo Chemical Inc., as a carbodiimide-based water-soluble resin crosslinking agent

•X-3: "DENACOL (registered trademark) EX-521" (tradename) produced by Nagase Chemtex Co., Ltd., as a water-soluble epoxy-based crosslinking agent

•D-1: A water dispersion of silica fine particles (average particle diameter: 60 nm)

Table 2

| Coating agent | Polyurethane | | Other resins | |
|---|---|---|---|---|
| | Kind | Amount added | Kind | Amount added |
| Coating agent 1 | U-1 | 55% | - | - |
| Coating agent 2 | U-1 | 55% | - | - |
| Coating agent 3 | U-2 | 55% | - | - |
| Coating agent 4 | U-2 | 55% | - | - |
| Coating agent 5 | U-3 | 55% | - | - |
| Coating agent 6 | U-3 | 55% | - | - |
| Coating agent 7 | U-2 | 55% | - | - |
| Coating agent 8 | U-1 | 95% | - | - |
| Coating agent 9 | - | - | - | - |
| Coating agent 10 | - | - | E-1 | 55% |

| Coating agent | Crosslinking agent | | Fine particles | |
|---|---|---|---|---|
| | Kind | Amount added | Kind | Amount added |
| Coating agent 1 | X-1 | 40% | D-1 | 5% |
| Coating agent 2 | X-2 | 40% | D-1 | 5% |
| Coating agent 3 | X-1 | 40% | D-1 | 5% |
| Coating agent 4 | X-2 | 40% | D-1 | 5% |
| Coating agent 5 | X-1 | 40% | D-1 | 5% |
| Coating agent 6 | X-2 | 40% | D-1 | 5% |
| Coating agent 7 | X-3 | 40% | D-1 | 5% |
| Coating agent 8 | - | - | D-1 | 5% |
| Coating agent 9 | X-2 | 95% | D-1 | 5% |

(continued)

| Coating agent | Crosslinking agent | | Fine particles | |
|---|---|---|---|---|
| | Kind | Amount added | Kind | Amount added |
| Coating agent 10 | X-1 | 40% | D-1 | 5% |

Example 1:

The above polyester (2), the above polyester (4) and the carbon black master batch 1 (BMB-1) were mixed with each other at a mixing weight ratio of 65:30:5 to obtain a polyester mixture as a raw material. The resulting raw material was charged into a vented twin-screw extruder, and melted and extruded at 290°C from the vented twin-screw extruder. The thus extruded molten sheet was allowed to adhere onto a casting drum whose surface temperature was maintained at 40°C by an electrostatic pinning method to rapidly cool and solidify the sheet, thereby obtaining an unoriented sheet. The longest retention time of the above melting and extruding step was 11 min. The thus obtained sheet was drawn at 85°C at a draw ratio of 3.6 times in a longitudinal direction thereof by a roll drawing method. At this time, a surface of the resulting film was subjected to corona discharge treatment, and then the coating agent 1 as shown in Table 2 above was applied onto the thus treated surface of the sheet using a bar coater such that the coating amount of the coating agent 1 was adjusted to 0.03 g/m$^2$ as measured on the finally obtained film. Next, the resulting coated sheet was introduced into a tenter, and dried therein at 100°C and then drawn at 110°C at a draw ratio of 3.9 times in a lateral direction thereof. The thus biaxially oriented sheet was further subjected to heat-setting at 220°C and then contracted by 4% at 200°C in a width direction thereof, thereby obtaining a film having a thickness of 50 $\mu$m. The properties and evaluation results of the thus obtained film are shown in Table 3 below. The color tone of the resulting film was a black color similar to that of the photovoltaic cells, and exhibited a high hiding power.

Example 2:

The above polyester (2) and the above polyester (4) were mixed with each other at a mixing weight ratio of 70:30 to obtain a polyester mixture as a raw material for a polyester (A) layer, and further the polyester (2) and the carbon black master batch 1 (BMB-1) were mixed with each other at a mixing weight ratio of 90:10 to obtain a polyester mixture as a raw material for a polyester (B) layer. The resulting raw materials were charged into two separate vented twin-screw extruders, respectively, melted and extruded at 290°C from the respective vented twin-screw extruders, laminated through a multi-manifold die to form a molten sheet having a layer structure ratio of A/B/A = 3/44/3, and then allowed to adhere onto a casting drum whose surface temperature was maintained at 40°C to rapidly cool and solidify the sheet by an electrostatic pinning method, thereby obtaining an unoriented sheet. The longest retention time of the above melting and extruding step was 14 min. The thus obtained sheet was drawn at 85°C at a draw ratio of 3.6 times in a longitudinal direction thereof by a roll drawing method. At this time, a surface of the polyester (A) layer was subjected to corona discharge treatment, and then the coating agent 1 as shown in Table 2 above was applied onto the thus treated surface of the sheet using a bar coater such that the coating amount of the coating agent 1 was adjusted to 0.02 g/m$^2$ as measured on the finally obtained film. Next, the resulting coated sheet was introduced into a tenter, and dried therein at 100°C and then drawn at 110°C at a draw ratio of 3.9 times in a lateral direction thereof. The thus biaxially oriented sheet was further subjected to heat-setting at 220°C and then contracted by 4% at 200°C in a width direction thereof, thereby obtaining a film having a thickness of 50 $\mu$m. The properties and evaluation results of the thus obtained film are shown in Table 3 below. The color tone of the resulting film was a black color similar to that of the photovoltaic cells, and exhibited a high hiding power.

Example 3:

The same procedure as in Example 2 was conducted except that the raw material for a polyester (B) layer was replaced with a polyester mixture prepared by mixing the polyester (2), the carbon black master batch 1 (BMB-1) and the phthalocyanine blue master batch (BMB-2) with each other at a mixing weight ratio of 80:10:10, thereby obtaining a film having a thickness of 50 $\mu$m. The longest retention time of the above melting and extruding step was 14 min. The properties and evaluation results of the thus obtained film are shown in Table 3 below. The color tone of the resulting film was a slightly bluish black color similar to that of the photovoltaic cells, and exhibited a high hiding power.

Example 4:

The same procedure as in Example 1 was conducted except that a polyester mixture prepared by mixing the polyester (6), the polyester (4) and the carbon black master batch 3 (BMB-3) with each other at a mixing weight ratio of 65:30:5 was used as a raw material, thereby obtaining a film having a thickness of 50 $\mu$m. The longest retention time of the above melting and extruding step was 11 min. The properties and evaluation results of the thus obtained film are shown in Table 3 below. The color tone of the resulting film was a black color similar to that of the photovoltaic cells, and exhibited a high hiding power.

Example 5:

The same procedure as in Example 1 was conducted except that a polyester mixture prepared by mixing the polyester (1), the polyester (2), the polyester (4) and the carbon black master batch 1 (BMB-1) with each other at a mixing weight ratio of 40:25:30:5 was used as a raw material, thereby obtaining a film having a thickness of 50 $\mu$m. The longest retention time of the above melting and extruding step was 11 min. The properties and evaluation results of the thus obtained film are shown in Table 3 below. The color tone of the resulting film was a black color similar to that of the photovoltaic cells, and exhibited a high hiding power.

Comparative Example 1:

The same procedure as in Example 1 was conducted except that a polyester mixture prepared by mixing the polyester (1), the polyester (4) and the carbon black master batch 1 (BMB-1) with each other at a mixing weight ratio of 65:30:5 was used as a raw material, thereby obtaining a film having a thickness of 50 $\mu$m. The longest retention time of the above melting and extruding step was 11 min. The properties and evaluation results of the thus obtained film are shown in Table 4 below. The color tone of the resulting film was a black color similar to that of the photovoltaic cells, and exhibited a high hiding power.

Comparative Example 2:

The same polyester raw materials as used in Example 4 were melted and extruded. At this time, the extrusion output and line speed were reduced such that the longest residence time of the melting and extruding step was 21 min. The subsequent procedure was conducted in the same manner as in Example 3, thereby obtaining a film having a thickness of 50 $\mu$m. The properties and evaluation results of the thus obtained film are shown in Table 4 below. The color tone of the resulting film was a black color similar to that of the photovoltaic cells, and exhibited a high hiding power.

Comparative Example 3:

The same procedure as in Example 1 was conducted except that the raw material was replaced with a polyester mixture prepared by mixing the polyester (2), the polyester (4) and the white pigment master batch 1 (WMB-1) with each other at a mixing weight ratio of 65:30:5, thereby obtaining a film having a thickness of 50 $\mu$m. The longest retention time of the above melting and extruding step was 11 min. The properties and evaluation results of the thus obtained film are shown in Table 4 below. The color tone of the resulting film was a white color and had a high contrast to a black color of the photovoltaic cells. Therefore, the white back surface-protective material film viewed through spaces between a plurality of the photovoltaic cells looked like white trimmed edge portions, so that the surface of the photovoltaic cell panel appeared to have geometric patterns thereon. As a result, such a photovoltaic cell panel will be improper for installing in scenic zones.

Examples 6 to 9 and Comparative Examples 4 to 8:

The same procedure as in Example 2 was conducted except that the coating agent used for production of the coating layer was replaced with the coating agents 2 to 10 as shown in Table 2, thereby obtaining films. The properties and evaluation results of the thus obtained films are shown in Tables 5 and 6 below. The color tone of the resulting films was a black color similar to that of the photovoltaic cells, and exhibited a high hiding power. Meanwhile, the term "Co" appearing in "Laminated layer structure of film" in Tables 3 to 6 means a coating layer.

Table 3

| | Examples | | |
|---|---|---|---|
| | 1 | 2 | 3 |
| Laminated layer structure of film | Co/ single layer | Co/A/B/A | Co/A/B/A |
| (A) layer: | | | |
| Kind of particles | silica | silica | silica |
| Amount of particles (wt%) | 0.03 | 0.03 | 0.03 |
| Kind of particles | Carbon black | - | - |
| Amount of particles (wt%) | 0.5 | - | - |
| Thickness of layer ($\mu$m) | 50 | 3 | 3 |
| (B) layer | | | |
| Kind of particles | - | Carbon black | Carbon black |
| Amount of particles (wt%) | - | 1.0 | 0.5 |
| Kind of particles | - | - | PB[1] |
| Amount of particles (wt%) | - | - | 0.5 |
| Thickness of layer ($\mu$m) | - | 44 | 44 |
| Content of color pigment (g/m$^2$) | 0.35 | 0.62 | 0.62 |
| Kind of coating agent | 1 | 1 | 1 |
| Terminal carboxylic acid content (equivalent/t) | 21 | 22 | 22 |
| Phosphorus element content (ppm) | 0 | 0 | 0 |
| Retention rate of wet heat-resistant elongation at break of film | A | A | A |
| Adhesion strength to EVA | A | A | A |
| Wet heat-resistant adhesion strength to EVA | A | A | A |
| Adhesion strength to PVB | A | A | A |
| Wet heat-resistant adhesion strength to PVB | A | A | A |

Note:
1): Phthalocyanine blue

Table 3 (Continued)

| | Examples | |
|---|---|---|
| | 4 | 5 |
| Laminated layer structure of film | Co/ single layer | Co/ single layer |
| (A) layer: | | |
| Kind of particles | silica | silica |
| Amount of particles (wt%) | 0.03 | 0.03 |
| Kind of particles | Carbon black | Carbon black |
| Amount of particles (wt%) | 0.5 | 0.5 |
| Thickness of layer ($\mu$m) | 50 | 50 |
| (B) layer | | |
| Kind of particles | − | − |
| Amount of particles (wt%) | − | − |
| Kind of particles | | |
| Amount of particles (wt%) | − | − |
| Thickness of layer ($\mu$m) | − | − |
| Content of color pigment ($g/m^2$) | 0.35 | 0.35 |
| Coating agent No. | 1 | 1 |
| Terminal carboxylic acid content (equivalent/t) | 22 | 26 |
| Phosphorus element content (ppm) | 104 | 0 |
| Retention rate of wet heat-resistant elongation at break of film | B | B |
| Adhesion strength to EVA | A | A |
| Wet heat-resistant adhesion strength to EVA | B | B |
| Adhesion strength to PVB | A | A |
| Wet heat-resistant adhesion strength to PVB | A | A |

Note:
1): Phthalocyanine blue

Table 4

| | Comparative Examples | | |
|---|---|---|---|
| | 1 | 2 | 3 |
| Laminated layer structure of film | Co/ single layer | Co/ single layer | Co/ single layer |
| (A) layer: | | | |
| Kind of particles | silica | silica | silica |
| Amount of particles (wt%) | 0.03 | 0.03 | 0.03 |

(continued)

| | Comparative Examples | | |
|---|---|---|---|
| | 1 | 2 | 3 |
| Kind of particles | Carbon black | Carbon black | Titanium oxide |
| Amount of particles (wt%) | 0.5 | 0.5 | 2.5 |
| Thickness of layer ($\mu$m) | 50 | 50 | 50 |
| (B) layer | | | |
| Kind of particles | - | - | - |
| Amount of particles (wt%) | - | - | - |
| Kind of particles | - | - | - |
| Amount of particles (wt%) | - | - | - |
| Thickness of layer ($\mu$m) | - | - | - |
| Content of color pigment (g/m$^2$) | 0.35 | 0.35 | - |
| Coating agent No. | 1 | 1 | 1 |
| Terminal carboxylic acid content (equivalent/t) | 31 | 32 | 21 |
| Phosphorus element content (ppm) | 0 | 104 | 0 |
| Retention rate of wet heat-resistant elongation at break of film | C | C | A |
| Adhesion strength to EVA | A | A | A |
| Wet heat-resistant adhesion strength to EVA | C | C | A |
| Adhesion strength to PVB | A | A | A |
| Wet heat-resistant adhesion strength to PVB | C | C | A |

Table 5

| | Examples | | | |
|---|---|---|---|---|
| | 6 | 7 | 8 | 9 |
| Laminated layer structure of film | Co/A/B/ A | Co/A/B/ A | Co/A/B/ A | Co/A/B/ A |
| (A) layer: | | | | |
| Kind of particles | silica | silica | silica | silica |
| Amount of particles (wt%) | 0.03 | 0.03 | 0.03 | 0.03 |
| Kind of particles | - | - | - | - |
| Amount of particles (wt%) | - | - | - | - |
| Thickness of layer ($\mu$m) | 3 | 3 | 3 | 3 |
| (B) layer | | | | |
| Kind of particles | Carbon black | Carbon black | Carbon black | Carbon black |
| Amount of particles (wt%) | 1.0 | 1.0 | 1.0 | 1.0 |
| Kind of particles | - | - | - | - |
| Amount of particles (wt%) | - | - | - | - |
| Thickness of layer ($\mu$m) | 44 | 44 | 44 | 44 |
| Content of color pigment (g/m$^2$) | 0.62 | 0.62 | 0.62 | 0.62 |

(continued)

|  | Examples | | | |
|---|---|---|---|---|
|  | 6 | 7 | 8 | 9 |
| Coating agent No. | 2 | 3 | 4 | 7 |
| Phosphorus element content (ppm) | 0 | 0 | 0 | 0 |
| Terminal carboxylic acid content (equivalent/t) | 22 | 22 | 22 | 22 |
| Retention rate of wet heat-resistant elongation at break of film | A | A | A | A |
| Adhesion strength to EVA | A | A | A | B |
| Wet heat-resistant adhesion strength to EVA | A | A | A | B |
| Adhesion strength to PVB | A | A | A | A |
| Wet heat-resistant adhesion strength to PVB | A | A | A | A |

Table 6

| | Comparative Examples | | |
|---|---|---|---|
| | 4 | 5 | 6 |
| Laminated layer structure of film | Co/A/B/A | Co/A/B/A | Co/A/B/A |
| (A) layer: | | | |
| Kind of particles | silica | silica | silica |
| Amount of particles (wt%) | 0.03 | 0.03 | 0.03 |
| Kind of particles | – | – | – |
| Amount of particles (wt%) | – | – | – |
| Thickness of layer ($\mu$m) | 3 | 3 | 3 |
| (B) layer | | | |
| Kind of particles | Carbon black | Carbon black | Carbon black |
| Amount of particles (wt%) | 1.0 | 1.0 | 1.0 |
| Kind of particles | – | – | – |
| Amount of particles (wt%) | – | – | – |
| Thickness of layer ($\mu$m) | 44 | 44 | 44 |
| Content of color pigment ($g/m^2$) | 0.62 | 0.62 | 0.62 |
| Coating agent No. | 5 | 6 | 8 |
| Phosphorus element content (ppm) | 0 | 0 | 0 |
| Terminal carboxylic acid content (equivalent/t) | 22 | 22 | 22 |
| Retention rate of wet heat-resistant elongation at break of film | A | A | A |
| Adhesion strength to EVA | B | B | B |
| Wet heat-resistant adhesion strength to EVA | C | C | C |
| Adhesion strength to PVB | A | A | A |
| Wet heat-resistant adhesion strength to PVB | C | C | C |

## Table 6 (Continued)

| | Comparative Examples | |
|---|---|---|
| | 7 | 8 |
| Laminated layer structure of film* | Co/A/B/A | Co/A/B/A |
| (A) layer: | | |
| Kind of particles | silica | silica |
| Amount of particles (wt%) | 0.03 | 0.03 |
| Kind of particles | – | – |
| Amount of particles (wt%) | – | – |
| Thickness of layer ($\mu$m) | 3 | 3 |
| (B) layer | | |
| Kind of particles | Carbon black | Carbon black |
| Amount of particles (wt%) | 1.0 | 1.0 |
| Kind of particles | – | – |
| Amount of particles (wt%) | – | – |
| Thickness of layer ($\mu$m) | 44 | 44 |
| Content of color pigment ($g/m^2$) | 0.62 | 0.62 |
| Coating agent No. | 9 | 10 |
| Phosphorus element content (ppm) | 0 | 0 |
| Terminal carboxylic acid content (equivalent/t) | 22 | 22 |
| Retention rate of wet heat-resistant elongation at break of film | A | A |
| Adhesion strength to EVA | D | B |
| Wet heat-resistant adhesion strength to EVA | Not evaluated | C |
| Adhesion strength to PVB | C | A |
| Wet heat-resistant adhesion strength to PVB | C | C |

INDUSTRIAL APPLICABILITY

The film of the present invention can be suitably used, for example, as a film for a protective material for a backsheet of photovoltaic cells.

**Claims**

1.   A polyester film for a protective material for a backsheet of photovoltaic cells, comprising:

a polyester base film having a carboxyl terminal group content of not more than 26 equivalents/t and comprising a color pigment, and
a coating layer formed on at least one surface of the polyester film which comprises a polyurethane having a polycarbonate skeleton or a polyether skeleton, and a crosslinking agent.

2.   The polyester film for a protective material for a backsheet of photovoltaic cells according to claim 1, wherein the crosslinking agent is a polymer comprising an oxazoline group or a carbodiimide group.

3. The polyester film for a protective material for a backsheet of photovoltaic cells according to claim 1 or 2, wherein the color pigment is carbon black.

4. The polyester film for a protective material for a backsheet of photovoltaic cells according to any one of claims 1 to 3, wherein a weight ratio of the crosslinking agent to the polyurethane (crosslinking agent/polyurethane) is 10/90 to 90/10.

5. The polyester film for a protective material for a backsheet of photovoltaic cells according to any one of claims 1 to 4, further comprising an ethylene-vinyl acetate copolymer resin layer which is laminated on the coating layer.

6. The polyester film for a protective material for a backsheet of photovoltaic cells according to any one of claims 1 to 4, further comprising a polyvinyl butyral resin layer which is laminated on the coating layer.

## INTERNATIONAL SEARCH REPORT

| | International application No. |
|---|---|
| | PCT/JP2011/065051 |

A. CLASSIFICATION OF SUBJECT MATTER
*H01L31/042*(2006.01)i, *B32B27/36*(2006.01)i

According to International Patent Classification (IPC) or to both national classification and IPC

B. FIELDS SEARCHED

Minimum documentation searched (classification system followed by classification symbols)
H01L31/042, B32B27/36

Documentation searched other than minimum documentation to the extent that such documents are included in the fields searched
Jitsuyo Shinan Koho          1922-1996   Jitsuyo Shinan Toroku Koho    1996-2011
Kokai Jitsuyo Shinan Koho    1971-2011   Toroku Jitsuyo Shinan Koho    1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2006-175764 A  (Mitsubishi Polyester Film Corp.), 06 July 2006 (06.07.2006), entire text (Family: none) | 1-6 |
| Y | JP 2-158633 A  (Diafoil Co., Ltd.), 19 June 1990 (19.06.1990), entire text (Family: none) | 1-6 |
| Y | WO 2006/106844 A1  (Toppan Printing Co., Ltd.), 12 October 2006 (12.10.2006), paragraph [0033] & EP 1873841 A1          & CN 101176211 A | 1-6 |

| ☒ | Further documents are listed in the continuation of Box C. | ☐ | See patent family annex. |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 July, 2011 (20.07.11) | 02 August, 2011 (02.08.11) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

| International application No. |
| --- |
| PCT/JP2011/065051 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y<br>A | JP 11-052514 A  (Mitsubishi Polyester Film Corp.),<br>26 February 1999 (26.02.1999),<br>paragraphs [0004] to [0005], [0048] to [0061]<br>(Family: none) | 6<br>1-5 |

Form PCT/ISA/210 (continuation of second sheet) (July 2009)

**REFERENCES CITED IN THE DESCRIPTION**

**Patent documents cited in the description**

- JP 2006152013 A
- JP 59005216 A
- JP 59217755 A